# EUROPÄISCHE PATENTSCHRIFT

(11) **EP 2 107 648 B1**
(45) Veröffentlichungstag und Bekanntmachung des Hinweises auf die Patenterteilung: **17.05.2017**
(21) Anmeldenummer: 09155230.7
(22) Anmeldetag: 16.03.2009
(51) Int. Cl.: H01R 13/658, H01R 9/03, H05K 9/00, H01R 13/514, H01R 13/74

(54) **Steckverbinder mit einer Schirmauflage**
Connector with a shielding-screen support
Connecteur avec une plaque de support utilisée comme blindage

(30) Priorität: 31.03.2008 DE 202008004428 U
(43) Veröffentlichungstag der Anmeldung: 07.10.2009
(73) Patentinhaber: Weidmüller Interface GmbH & Co. KG, 32758 Detmold (DE)
(72) Erfinder: Stuckmann, Peter, 32791 Lage (DE); Vianden, Peter, 32689 Kalletal (DE); Beck, Hubert, 97922 Lauda-Königshofen (DE); Unger, Heinz, 97828 Marktheidenfeld (DE); Mussauer, Christian, 97837 Erlenbach-Tiefenthal (DE); Sichmann, Wolfgang, 35625 Hüttenberg (DE)
(74) Vertreter: Dantz, Jan Henning

(56) Entgegenhaltungen:
- EP-A- 0 865 113
- DE-U1- 9 202 912
- DE-U1-202006 016 545
- US-A- 5 634 817
- US-A1- 2005 221 656
- US-B1- 6 174 182
- US-B1- 6 213 814
- JIM NADOLNY ED - INSTITUTE OF ELECTRICAL AND ELECTRONICS ENGINEERS: "EMI Design of Shielded Cable Assemblies" 2002 IEEE INTERNATIONAL SYMPOSIUM ON ELECTROMAGNETIC COMPATIBILITY. EMC. SYMPOSIUM RECORD. MINNEAPOLIS, MN, AUG. 19 - 23, 2002; [INTERNATIONL SYMPOSIUM ON ELECTROMAGNETIC COMPATIBILITY], NEW YORK, NY : IEEE, US, 1. Juli 2007 (2007-07-01), Seiten 1-6, XP031128095 ISBN: 978-0-7803-7264-1

## Beschreibung

Die Erfindung betrifft eine Steckverbindung nach dem Oberbegriff des Anspruchs 1.

Es ist bekannt, Schirmauflagen über Schrauben mit einem korrespondierenden leitenden Element, insbesondere einem Gehäuse, z.B. mit einem Durchbruch oder mit einer Schirmanbindung an einem Gegenstecker, zu verbinden. Die Handhabung dieser Steckverbinder ist aber relativ aufwändig. Zudem ist der elektrische Kontaktbereich relativ undefiniert bzw. stark vom Bediener abhängig.

Eine als Schirmblech ausgebildete Schirmauflage für einen Steckverbinder ist aus der EP 1 788 665 A2 bekannt. Die US 2005/0221656 B1 offenbart einen Steckverbinder mit einer die Steckkontakte umgebenden leitenden Hülse.

Die Druckschriften US 6,174,182 B1 und US 6,213,814 B1 offenbaren Verbinder, die jeweils vertikal zur Steckrichtung angeordnete Platten mit Federelementen als Erdungsabschnitte vorsehen.

Gegenüber diesem Stand der Technik ist die Aufgabe der Erfindung, die Handhabung zu vereinfachen und den elektrischen Kontakt zwischen der Schirmauflage und einem leitenden Gegenstück, insbesondere einem Gehäuseblech, zu verbessern.

Die Erfindung löst die Aufgabe durch den Gegenstand des Anspruchs 1.

Die Schirmauflage des Steckverbinders ist einfach ausgebildet und leicht handhabbar. Sie ist auch an weniger gut zugänglichen Stellen mit einem einfachen Steckvorgang in ihre Kontaktstellung an der Gehäusewand bringbar und realisiert einen definierten und bedienungsunabhängigen elektrischen Kontakt zwischen der Schirmauflage und der Wand.

Die Erfindung schafft zudem den vorteilhaften Gegenstand des Anspruchs 10, wonach die Schirmauflage derart ausgestaltet ist, dass an ihr mit wenigstens zwei Befestigungsmitteln ein Kabel in einfacher Weise zumindest einmal zugentlastend festgelegt ist und zumindest kabelschirmkontaktierend festgelegt ist.

Vorzugsweise weist das Kabel zwei Kabelschirme auf und diese Kabelschirme sind an zwei axial zueinander versetzten Stellen an der Schirmauflage festgelegt.

Besonders einfach und kostengünstig ist eine Auslegung der Befestigungsmittel als Kabelbinder, welche den Kabelmantel und den wenigstens einen Kabelschirm an der Schirmauflage festlegen.

Nach der auch selbständig zu betrachtenden Weiterbildung des Anspruchs 12 wird an dem Steckverbinder direkt ein Abschnitt mit Signalkontakten ausgebildet, so dass in einfacher Weise die Funktionen von zwei nach dem Stand der Technik an sich getrennten Steckern in nur einen Stecker integriert werden.

Vorteilhafte Ausgestaltungen der Erfindung sind den Unteransprüchen zu entnehmen. Nachfolgend wird die Erfindung unter Bezug auf die Zeichnung anhand von Ausführungsbeispielen näher beschrieben. Es zeigt:
- Fig. 1: eine perspektivische Ansicht eines Leiterplattensteckverbinders mit einer Schirmauflage und eines Gehäuseabschnittes mit einer Leiterplatte und einem auf der Leiterplatte angeordneten korrespondierenden Leiterplattensteckverbinder;
- Fig. 2 bis 4: verschiedene weitere Ansichten von Abschnitten des Leiterplattensteckverbinders mit der Schirmauflage aus Fig. 1; und
- Fig. 5: eine Seitenansicht eine Teils der Anordnung aus Fig. 1 bei einem Zusammenstecken;
- Fig. 6: eine perspektivische Ansicht der Schirmauflage und eines anzuschließenden Kabels;
- Fig. 7: eine Schnittansicht durch einen vom Leiterplattensteckverbinder abgewandten Endbereich der Schirmauflage und durch das auf dieser festgelegte Kabel; und
- Fig. 8: eine perspektivische Ansicht des Endbereiches der Schirmauflage mit dem darauf befestigten Kabel.

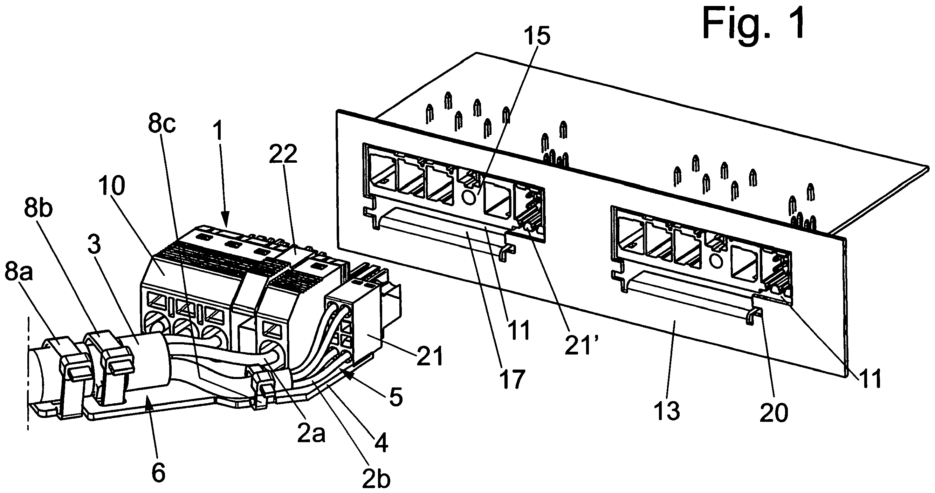

Fig. 1 bis 5 zeigen jeweils einen Leiterplattensteckverbinder 1, an dessen vom Steckgesicht abgewandten Seite Leiter 2a (insbesondere zum Leistungsanschluss), 2b (insbesondere zum Signalleiteranschluss) eines Kabels 3 angeschlossen sind, wobei der Leiterplattensteckverbinder 1 und der zum Leiterplattensteckverbinder gewandte Endbereich des Kabels 3 auf einer Schirmauflage 4 befestigt sind. Die Leiter 2a haben vorzugsweise einen größeren Querschnitt als die Leiter 2b.

Die Schirmauflage 4 ist als Schirmblech aus einem leitenden Metall ausgebildet und weist einen Auflage- und Befestigungsbereich 5 für den Leiterplattensteckverbinder 1 auf und einen Auflage- und Befestigungsbereich 6 für das Kabel 3. Die Bereiche 5 und 6 sind hier im einem Winkel α winklig zueinander ausgerichtet, wobei der Winkel α hier beispielhaft zwischen 15 und 65° liegt.

Der Leiterplattensteckverbinder 1 ist mit einem Befestigungsmittel am Auflage- und Befestigungsbereich 5 für den Leiterplattensteckverbinder 1 festgelegt. Hier wird zu diesem Zweck eine Schraube und/oder wenigstens ein Rastmittel verwendet, wobei die Schraube den Leiterplattensteckverbinder durchsetzt und in einer Schraubbohrung 7 der Schirmauflage verschraubbar ist. Alternative Ausgestaltungen sind denkbar, so könnte eine Schraube mit dem Leiterplattensteckverbinder verschraubt sein, die durch eine Bohrung in der Schirmauflage gesteckt wird und im Gehäuse des Steckverbinders verschraubt ist.

Das Kabel 2 ist hier mit als Kabelbindern 8 ausgelegten Befestigungsmitteln, welche um das Kabel 3 gelegt sind und Öffnungen 9a, 9b, 9c im Auflage- und Befestigungsbereich 6 durchsetzen, an der Schirmauflage 4 festgelegt. Andere Befestigungsmittel wären ebenfalls denkbar.

Im vorliegenden Ausführungsbeispiel werden hierzu drei Kabelbinder 8a, 8b, 8c verwendet. Diese Kabelbinder 8a, 8b, 8c sind axial - bezogen auf das Kabel 3 - zueinander versetzt an der Schirmauflage 4 befestigt.

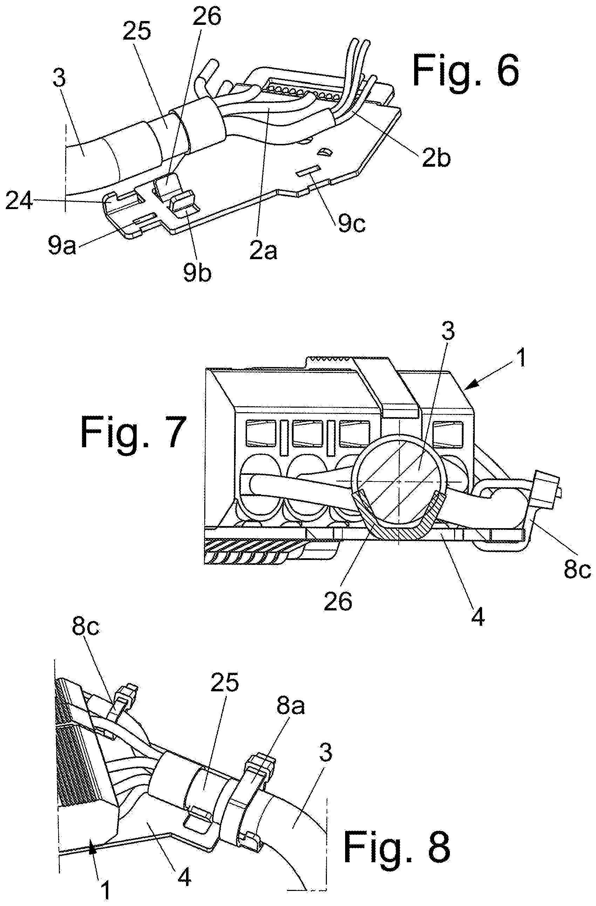

An dem von dem Leiterplattensteckverbinder abgewandten Ende der Schirmauflage 4 dient ein erster Kabelbinder 8a, welcher um den äußeren Kabelmantel des Kabels 3 gelegt ist und eine erste Öffnung 9a der Schirmauflage 4 durchsetzt, dazu, eine zugentlastende Festlegung des Kabels 3 zu realisieren. An der Schirmauflage 4 kann ein umgebogener Bereich 24 vorgesehen sein, welcher eine Art Kabelführung realisiert (siehe hierzu auch Fig. 6).

In einem hierzu axial - vorzugsweise in Richtung auf den Leiterplattensteckverbinder 1 zu - versetzten Bereich ist das Kabel abschnittsweise abgemantelt, so dass ein Kabelschirm 25 freigelegt ist. In diesem Bereich wird das abgemantelte Kabel 3 mit einem weiteren Kabelbinder 8b an die Schirmauflage 4 gelegt. Aus der Öffnung 9b können Abwinklungen 26 ausgebogen sein, welche ergänzend eine Führung und einen guten elektrischen Kontakt zwischen der Schirmauflage 4 und dem Kabelschirm 25 sicherstellen (siehe auch Fig. 6).

Im vorliegenden Fall weist das Kabel 3 zudem einen weiteren Innenschirm 27 auf, welcher lediglich ein Teil der Leiter 2, die Leiter 3b, umfasst. Diese Leiter 2b dienen als Signalleiter 2b, wohingegen die Leiter 2a vorzugsweise zumindest teilweise zur Energieversorgung dienen. Der Innen- bzw. Extraschirm (nicht dargestellt) ist an einer dritten Öffnung 9c wiederum weiter axial versetzt mit einem dritten Kabelbinder 8c an der Schirmauflage 4 leitend festgelegt (siehe Fig. 1 und zum Verständnis Fig. 6).

Die derart realisierte Trennung in eine mechanische Zugentlastung und zwei Schirmauflagen ist konstruktiv einfach und ermöglicht eine Vorkonfektionierung. Sie realisiert zudem einen übersichtlichen Aufbau.

Der Leiterplattensteckverbinder 1 weist ein Gehäuse 10 aus einem Isolierstoff auf, in dem hier in einer Reihe und Ebene nebeneinander angeordnete Kontakte ausgebildet sind (hier nicht zu erkennen).

Am Gehäuse 10 kann ein Abschnitt 21 mit Signalkontakten angeordnet sein, der u.U. keiner Schirmung bedarf. In diesen Abschnitt sind die Signalleiter 2b geführt. Derart wird ein Hybridstecker gebildet.

Das Gehäuse kann ferner wenigstens ein Verriegelungsmittel 22 zum Verriegeln am korrespondierenden Steckverbinder aufweisen. Dieses Verriegelungsmittel 22 ist hier zwischen dem dritten und dem vierten Pol des Gehäuses 10 angeordnet und unterstützt mit seiner einfachen Einhandbedienung die Handhabung des Leiterplattensteckverbinders.

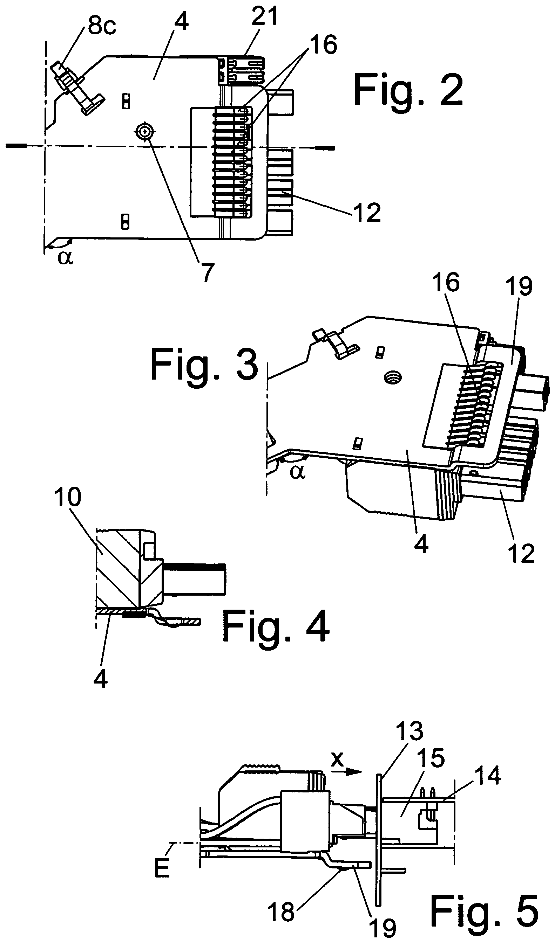

Der Leiterplattensteckverbinder 1 ist als Steckerteil ausgebildet, der ein Steckgesicht aufweist, das einen Steckbereich 12 aufweist, der durch einen Durchbruch bzw. eine Öffnung 11 einer Wandung 13 z.B. einen Gehäuses durchgesteckt werden kann, um einen auf einer Leiterplatte 14 angeordneten korrespondierenden Leiterplattensteckverbinder 15 zu kontaktieren bzw. um mit diesem zusammengesteckt zu werden (Fig. 5).

Durch die gewählte Anordnung des Leiterplattensteckverbinders mit dem Abschnitt 21 wird die Funktion von zwei ansonsten getrennten Steckverbindern in nur einen einzigen Steckverbinder integriert, der als ganzes in einer Einhandbedienung mit dem Leiterplattensteckverbinder 15 verbunden werden kann, der vorzugsweise einen zum Abschnitt 21 korrespondierenden Abschnitt 21' aufwiest. Der vorzugsweise direkt an das Gehäuse angespritzte Gehäuseabschnitt des Steckerabschnitts 21 weist hier eine andere Geometrie auf als das übrige Gehäuse des Steckverbinders. Es wäre alterbnativ auch denkbar, die Gehäuseform des Abschnittes 21 an die übrige Gehäuseform anzugleichen bzw. mehrere Kontakte in das am Steckverbinder vorhandene Steckgesicht bzw. den Steckbereich 12 zu integrieren.

Der Leiterplattensteckverbinder 15 ist hier korrespondierend zum Leiterplattensteckverbinder 1 als Stiftteil ausgebildet. Eine umgekehrte Anordnung mit einem Stiftteil auf der Leiterseite und einem Buchsenteil auf der Leiterplatte wäre denkbar.

Die Wand 13 besteht in diesem Beispiel aus einem elektrisch gut leitenden Material. Wenn die Wand dagegen aus einem nicht leitenden Material besteht, kann zur Aufnahme des Schirmkontaktes ein Rahmen aus elektrisch leitendem Material in dem Wandausschnitt befestigt werden, der über einen Anschluss für eine Masseleitung verfügt und dadurch geerdet werden kann (hier nicht dargestellt). Der Rahmen bildet dann einen Teil der Wand 13 aus.

Die Schirmauflage 4 kontaktiert im zusammengesteckten Zustand der Fig. 5 die Wand 13. Um auf einfache Weise einen elektrisch gut leitenden Kontakt zwischen der Schirmauflage 4 und der Wand 13 zu realisieren, weist die Schirmauflage hier einen auf ihr befestigten Streifen aus leitendem Material auf, der Federkontakte 16 aufweist, die aus der Ebene der Schirmauflage herausgebogen sind. Vorzugsweise sind die Federkontakte 16 zu der vom Leiterplattensteckverbinder 12 abgewandte Seiten hin aus der Ebene E der Schirmauflage herausgebogen. Vorzugsweise wird eine Mehrzahl, insbesondere mehr als drei, hier beispielhaft vierzehn, der Federkontakte 16 aus der Ebene E der Schirmauflage 4 herausgebogen.

Die Federkontakte 16 sind dazu ausgelegt, im zusammengesteckten Zustand federnd auf einen Abschnitt 17 der Wand 13 zu drücken, um die Wand 13 elektrisch leitend zu kontaktieren. Der Abschnitt 17 schützt die Federkontakte 16 auch vor einer Beschädigung.

Dies wird hier in vorteilhafter Weise dadurch erreicht, dass senkrecht aus der Haupterstreckungsebene der Wand 13 parallel zur Steckrichtung X ein Abschnitt herausgebogen ist, der als Kontakt- und Auflagefläche 17 für die Federkontakte 16 dient.

Die Federkontakte 16 sind derart bemessen, dass sie im zusammengesteckten Zustand als Abschnitt der Schirmauflage 4 die Öffnung 11 bzw. den Wanddurchbruch durchsetzen und federnd die Kontakt- und Auflagefläche 17 kontaktieren. Hierzu können die Federkontakte 16 jeweils eine Einprägung 18 aufweisen, die einen im Wesentlichen streifenförmigen Kontakt zur Kontakt- und Auflagefläche 17 sicherstellt. Die Federkontakte können auch einstückig mit der Schirmauflage 4 ausgebildet sein oder an dieser mit dem bereits erwähnten Streifen befestigt sein, wobei sie dann auch aus einem anderen Material als diese bestehen können, welches z.B. gute federnde und leitende Eigenschaften aufweist.

Es ist möglich, z.B. beim Ausstanzen der Schirmauflage 4 aus einem Blech einen die Federkontakte 16 insbesondere in Steckrichtung umgebenden Rahmenabschnitt 19 zu belassen bzw. auszubilden, welcher U-förmig sich an die Schirmauflage 4 in Steckrichtung anschließend die Federkontakte 16 gegen ein unbeabsichtigtes Verbiegen und Fehlstecken beim zusammenstecken der Leiterplattensteckverbinder 1 und 15 schützt. Der Abschnitt16 könnte auch durch einen an der Wand 13 befestigten Winkel gebildet werden.

Vorzugsweise wird der Rahmenabschnitt 19 jedenfalls abschnittsweise wie die Federkontakte 16 aus der Haupterstreckungsebene E der Schirmauslage in die Ebene der freien Enden der Federkontakte 16 gebogen, so dass ein besonders wirksamer Biegeschutz für die Federkontakte realisiert wird.

Es ist optional denkbar, dass Seitenbereiche des Rahmenabschnitts 19 in schlitzartigen Aussparungen 20 der Wand 13 stabilisierend abgestützt werden, was auch eine bessere Führung beim Zusammenstecken realisiert. Es wäre zudem auch denkbar, die Federkontakte am Steckverbinder 15 bzw. am Gehäuse 13 (Bereich 17) vorzusehen.

**Bezugszeichen**

| | |
|---|---|
| Leiterplattensteckverbinder | 1 |
| Leiter | 2a, b |
| Kabel | 3 |
| Schirmauflage | 4 |
| Auflage- und Befestigungsbereich | 5,6 |
| Schraubbohrung | 7 |
| Kabelbinder | 8a, b, c |
| Öffnungen | 9a, b, c |
| Gehäuse | 10 |
| Durchbruch, Öffnung | 11 |
| Steckbereich | 12 |
| Wand | 13 |
| Leiterplatte | 14 |
| Steckverbinder | 15 |
| Federkontakte | 16 |
| Kontakt- und Auflagefläche | 17 |
| Einprägung | 18 |
| Rahmenabschnitt | 19 |
| Aussparungen | 20 |
| Abschnitte | 21, 21' |
| Vernegelungsmittel | 22 |
| Bereich | 24 |
| Kabelschirm | 25 |
| Abwinklungen | 26 |

## Patentansprüche

1. Steckverbindung mit einem Steckverbinder, insbesondere Leiterplattensteckverbinder (1), und einem weiteren Steckverbinder auf einer Leiterplatte und mit einer Wand (13) mit einer Öffnung (11), der ein Steckverbinder-Gehäuse (10) aufweist, das mit einer Schirmauflage (4) versehen ist, welche zur Kontaktierung der leitenden Wand (13), vorzugsweise eines Gehäuses, im Bereich des korrespondierenden Steckverbinders (15) ausgebildet ist, wobei aus einer Haupterstreckungsebene (E) der Schirmauflage (4) einer oder vorzugsweise mehrere Federkontakte (16) vorstehen, die dazu ausgelegt sind, einen Abschnitt (17) der zu kontaktierenden leitenden Wand (13), im Bereich des weiteren Steckverbinders (15) zu kontaktieren,
**dadurch gekennzeichnet, dass**
der Abschnitt (17) aus der Haupterstreckungsebene der Wand (13) so heraus gebogen ist, dass er sich parallel zur Steckrichtung (X) erstreckt, wobei die Federkontakte (16) im zusammengesteckten Zustand federnd auf den Abschnitt (17) drücken.

2. Steckverbindung nach Anspruch 1, **dadurch gekennzeichnet, dass** die Federkontakte (16) an einem an der Schirmauflage (4) befestigten Streifenabschnitt ausgebildet sind und/oder dass die Federkontakte (16) aus der Schirmauflage (4) teilausgestanzt und heraus gebogen sind.

3. Steckverbindung nach Anspruch 2, **dadurch gekennzeichnet, dass** mehr als drei der Federkontakte (16) an der Schirmauflage (4) ausgebildet sind.

4. Steckverbindung nach einem der vorstehenden Ansprüche, **dadurch gekennzeichnet, dass** den Federkontakten (16) ein Steckschutz zum Schutz vor Beschädigung und zur Führung beim Steckvorgang zugeordnet ist, der vorzugsweise als Rahmenabschnitt (19) ausgebildet ist.

5. Steckverbindung nach Anspruch 4, **dadurch gekennzeichnet, dass** der Rahmenabschnitt (19) eine U-Form aufweist und einstückig mit der Schirmauflage (4) ausgebildet ist.

6. Steckverbindung nach einem der Ansprüche 4 - 5, **dadurch gekennzeichnet, dass** der Rahmenabschnitt (19) in die Ebene der Federkontakte (16) gebogen ist und dass der Rahmenabschnitt (19) die Federkontakte vorzugsweise in Steckrichtung (X) umgibt.

7. Steckverbindung nach einem der vorstehenden Ansprüche, **dadurch gekennzeichnet, dass** die Schirmauflage (4) als Schirmblech aus einem leitenden Metall ausgebildet ist und einen Auflage- und Befestigungsbereich (5) für den Leiterplattensteckverbinder (1) und einen Auflage- und Befestigungsbereich (6) für das Kabel (3) aufweist.

8. Steckverbindung nach Anspruch 7, **dadurch gekennzeichnet, dass** die Auflage- und Befestigungsbereiche (5, 6) im einem Winkel (α) winklig zueinander ausgerichtet sind, wobei der Winkel (α) vorzugsweise zwischen 15° und 65° liegt.

9. Steckverbindung nach einem der Ansprüche 7 - 8, **dadurch gekennzeichnet, dass** der Leiterplattensteckverbinder (1) mit einem Befestigungsmittel am Auflage- und Befestigungsbereich (5) für den Leiterplattensteckverbinder (1) festgelegt ist.

10. Steckverbindung nach einem der vorstehenden Ansprüche, **dadurch gekennzeichnet, dass** die Schirmauflage (4) derart ausgestaltet ist, dass an ihr mit wenigstens zwei Befestigungsmitteln (8a, 8b, 8c) ein Kabel (3) zumindest einmal zugentlastend festgelegt ist und zumindest kabelschirmkontaktierend festgelegt ist.

11. Steckverbindung nach Anspruch 10, **dadurch gekennzeichnet, dass** das Kabel (3) zwei Kabelschirme (25) aufweist und dass diese Kabelschirme (25) an zwei axial zueinander versetzten Stellen an der Schirmauflage (4) kontaktierend festgelegt sind und dass die Befestigungsmittel vorzugsweise Kabelbinder (8a, 8b, 8c) sind, welche jeweils den Kabelmantel oder den wenigstens einen Kabelschirm an der Schirmauflage (4) festlegen.

12. Steckverbindung nach einem der vorstehenden Ansprüche, **dadurch gekennzeichnet, dass** an den Steckverbinder direkt ein Abschnitt (21) mit Signalkontakten angeformt ist.

13. Steckverbindung nach einem der vorstehenden Ansprüche, **dadurch gekennzeichnet, dass** die Federkontakte (16) derart bemessen sind, dass sie im zusammengesteckten Zustand als Abschnitt der Schirmauflage (4) die Öffnung (12) durchsetzen und federnd die Kontakt- und Auflagefläche (17) kontaktieren und dass vorzugsweise Seitenbereiche des Rahmenabschnitts (19) in schlitzartigen Aussparungen (20) der Wand (13) stabilisierend abgestützt sind.

## Claims

1. A plug connection, comprising a plug connector, especially a printed circuit board connector (1), and a further plug connector on a printed circuit board and a wall (13) with an opening (11) having a plug connector housing (10) which is provided with a shield support (4) formed for contacting the conductive wall (13), preferably a housing, in the region of the corresponding plug connector (15), wherein one or preferably multiple spring contacts (16) protrude from a main extension plane (E) of the shield support (4), said spring contacts being formed to contact a section (17) of the conductive wall (13) to be contacted in the region of the further plug connector (15), **characterized in that** the section (17) is bent out of the main extension plane of the wall (13) in such a way that it extends parallel to the plug-in direction (X), wherein the spring contacts (16), in the assembled state, resiliently press on the section (17).

2. A plug connection according to claim 1, **characterized in that** the spring contacts (16) are formed on a strip section fastened to the shield support (4), and/or that the spring contacts (16) are partly punched from or bent out of the shield support (4).

3. A plug connection according to claim 2, **characterized in that** more than three of the spring contacts (16) are formed on the shield support (4).

4. A plug connection according to one of the preceding claims, **characterized in that** the spring contacts (16) are associated with a plug-in protector for protection from damage and for guidance during the plug coupling process, said protector preferably being formed as a frame section (19).

5. A plug connection according to claim 4, **characterized in that** the frame section (19) is U-shaped and is integrally formed with the shield support (4).

6. A plug connection according to one of the claims 4 to 5, **characterized in that** the frame section (19) is bent into the plane of the spring contacts (16) and that the frame section (19) surrounds the spring contacts preferably in the plug-in direction (X).

7. A plug connection according to one of the preceding claims, **characterized in that** the shield support (4) is formed as a shielding plate made from a conductive metal and comprises a support and fastening region (5) for the printed circuit board connector (1) and a support and fastening region (6) for the cable (3).

8. A plug connection according to claim 7, **characterized in that** the support and fastening regions (5, 6) are angularly oriented at an angle (α) with respect to each other, wherein the angle (α) preferably lies between 15° and 65°.

9. A plug connection according to one of the claims 7 to 8, **characterized in that** the printed circuit board connector (1) is fastened by means of a fastening means to the support and fastening region (5) for the printed circuit board connector (1).

10. A plug connection according to one of the preceding claims, **characterized in that** the shield support (4) is formed in such a way that a cable (3) is fastened to said support at least once in a tension-relieving manner by means of at least two fastening means (8a, 8b, 8c) and is fastened at least in a manner that contacts the cable shield.

11. A plug connection according to claim 10, **characterized in that** the cable (3) comprises two cable shields (25), and that said cable shields (25) are fastened at two axially mutually offset points to the shield support (4) in a contacting manner, and that the fastening means are preferably cable ties (8a, 8b, 8c) which each fasten the cable sheath or the at least one cable shield to the shield support (4).

12. A plug connection according to one of the preceding claims, **characterized in that** a section (21) with signal contacts is directly integrally formed on the plug connector.

13. A plug connection according to one of the preceding claims, **characterized in that** the spring contacts (16) are dimensioned in such a way that in the mated state they penetrate the opening (12) as a section of the shield support (4) and resiliently contact the contact and support surface (17), and that preferably the side regions of the frame section (19) are supported in a stabilising manner in slot-shaped recesses (20) of the wall (13).

## Revendications

1. Connexion enfichée avec un connecteur enfichable, en particulier un connecteur enfichable de carte de circuits imprimés (1), et avec un autre connecteur enfichable sur une carte de circuits imprimés et avec une paroi (13) munie d'une ouverture (11) qui présente un boîtier de connecteur enfichable (10) muni d'un raccordement de blindage (4) qui est réalisé pour venir en contact avec la paroi conductrice (13), de préférence celle d'un boîtier, au niveau du connecteur enfichable (15) correspondant, un ou plusieurs contacts élastiques (16) dépassant d'un plan d'étendue principal (E) du raccordement de blindage (4) et étant réalisés pour venir en contact avec une partie (17) de la paroi conductrice (13) à mettre en contact au niveau de l'autre connecteur enfichable (15), **caractérisée en ce que** la partie (17) est recourbée à partir du plan d'étendue principal de la paroi (13) de telle sorte qu'elle s'étend parallèlement au sens d'enfichage (X), les contacts élastiques (16) appuyant de façon élastique sur la partie (17) dans l'état enfiché.

2. Connexion enfichée selon la revendication 1, **caractérisée en ce que** les contacts élastiques (16) sont formés sur une partie de bande fixée au raccordement de blindage (4) et/ou **en ce que** les contacts élastiques (16) sont partiellement découpés à l'emporte-pièce et recourbés à partir du raccordement de blindage (4).

3. Connexion enfichée selon la revendication 2, **caractérisée en ce que** plus de trois des contacts élastiques (16) sont formés sur le raccordement de blindage (4).

4. Connexion enfichée selon l'une des revendications précédentes, **caractérisée en ce que** les contacts élastiques (16) sont associés à une protection d'enfichage pour la protection contre les détériorations et pour le guidage lors de l'opération d'enfichage, qui est de préférence réalisée comme une partie de cadre (19).

5. Connexion enfichée selon la revendication 4, **caractérisée en ce que** la partie de cadre (19) est en forme de U et formée d'un seul tenant avec le raccordement de blindage (4).

6. Connexion enfichée selon l'une des revendications 4 à 5, **caractérisée en ce que** la partie de cadre (19) est recourbée dans le plan des contacts élastiques (16) et **en ce que** la partie de cadre (19) entoure les contacts élastiques, de préférence dans le sens d'enfichage (X).

7. Connexion enfichée selon l'une des revendications précédentes, **caractérisée en ce que** le raccordement de blindage (4) est réalisé comme une tôle d'écran en métal conducteur et présente une zone d'application et de fixation (5) pour le connecteur enfichable de carte de circuits imprimés (1) et une zone d'application et de fixation (6) pour le câble (3).

8. Connexion enfichée selon la revendication 7, **caractérisée en ce que** les zones d'application et de fixation (5, 6) sont orientées l'une par rapport à l'autre selon un angle (α), lequel angle (α) est de préférence compris entre 15° et 65°.

9. Connexion enfichée selon l'une des revendications 7 à 8, **caractérisée en ce que** le connecteur enfichable de carte de circuits imprimés (1) est fixé avec un moyen de fixation sur la zone d'application et de fixation (5) pour le connecteur enfichable de carte de circuits imprimés (1).

10. Connexion enfichée selon l'une des revendications précédentes, **caractérisée en ce que** le raccordement de blindage (4) est conformé de telle façon qu'un câble (3) y est fixé par au moins deux moyens de fixation (8a, 8b, 8c) avec au moins une décharge de traction et au moins en contact avec le blindage de câble.

11. Connexion enfichée selon la revendication 10, **caractérisée en ce que** le câble (3) présente deux blindages de câble (25) et **en ce que** ces blindages de câble (25) sont fixés en contact sur le raccordement de blindage (4) en deux points décalés dans le sens axial l'un par rapport à l'autre et **en ce que** les moyens de fixation sont de préférence des serre-câbles (8a, 8b, 8c), qui fixent chacun l'enveloppe de câble ou l'au moins un blindage de câble sur le raccordement de blindage (4).

12. Connexion enfichée selon l'une des revendications précédentes, **caractérisée en ce qu'**une partie (21) comportant des contacts de signal est formée directement sur le connecteur enfichable.

13. Connexion enfichée selon l'une des revendications précédentes, **caractérisée en ce que** les contacts élastiques (16) sont dimensionnés de telle façon que dans l'état enfiché, ils traversent l'ouverture (12) sous la forme d'une partie du raccordement de blindage (4) et viennent en contact élastique avec la surface de contact et d'application (17) et **en ce que** des parties latérales de la partie de cadre (19) s'appuient de préférence pour se stabiliser dans des découpes en forme de fentes (20) de la paroi (13).
